# EUROPEAN PATENT APPLICATION

(11) **EP 4 553 577 A2**
(43) Date of publication of application: **14.05.2025**
(21) Application number: 24204287.7
(22) Date of filing: 02.10.2024
(51) Int. Cl.: G03F 7/004, C07F 5/00, C07F 7/08, C07F 7/10, C07F 17/00

(54) **METHODS AND APPARATUS UTILIZING INDIUM-BASED PRECURSORS FOR INTEGRATED CIRCUIT MANUFACTURING**

(30) Priority: 10.11.2023 US 202318506838
(71) Applicant: INTEL Corporation, Santa Clara, CA 95054 (US)
(72) Inventor: MOKHTARZADEH, Charles, Portland, 91217 (US); SEMPRONI, Scott, Fair Lawn, 07410 (US); CLENDENNING, Scott B., Portland, 97225 (US)
(74) Representative: HGF

(57) **Abstract**

Methods and apparatus utilizing indium-based precursors in semiconductor manufacturing are disclosed. An example apparatus includes a substrate layer, the substrate layer to be included an integrated circuit package, and a photoresist on the substrate layer, the photoresist including indium.

## Description

### FIELD OF THE DISCLOSURE

This disclosure relates generally to semiconductor device fabrication and, more particularly, to methods and apparatus utilizing indium-based precursors for integrated circuit manufacturing.

### BACKGROUND

Semiconductor device fabrication includes various processes to manufacture integrated circuits or chips. Many processes involved in semiconductor device fabrication involve the use of photolithography. Photolithography involves the application of light onto a layer of light-sensitive material (e.g., a photoresist, also sometimes referred to simply as a resist) in a controlled manner to produce a pattern in the layer of material in which portions of the layer of material are retained while other portions are removed. Depending on the particular materials and techniques involved, the retained portions may correspond to regions of the layer of material that were exposed to the light while the removed portions correspond to regions that were not exposed to the light. However, in other situations, the retained portions may correspond to the regions not exposed to the light while the removed portions correspond to the regions that were exposed to the light. Often, the exposure of light onto a photoresist is controlled through the use of a photolithography mask (e.g., a photomask or simply mask) between the light source and the photoresist.

### BRIEF DESCRIPTION OF THE DRAWINGS

FIG. 1 illustrates an example integrated circuit (IC) package constructed in accordance with teachings disclosed herein.
FIG. 2 illustrates an example process to photolithographically pattern materials in the IC package of FIG. 1.
FIG. 3 illustrates another example process to photolithographically pattern materials in the IC package of FIG. 1.
FIG. 4 illustrates an example synthetic pathway that can be utilized to produce an indium-based precursor for an indium-based photoresist in accordance with examples herein.
FIG. 5 illustrates another example synthetic pathway that can be utilized to produce an indium-based photoresist in accordance with examples herein.
FIG. 6 illustrates another example synthetic pathway that can be utilized to produce an indium-based photoresist in accordance with examples herein.
FIG. 7 illustrates another example synthetic pathway that can be utilized to produce an indium-based photoresist in accordance with examples herein.
FIG. 8 illustrates another example synthetic pathway that can be utilized to produce an indium-based photoresist in accordance with examples herein.
FIG. 9 illustrates another example synthetic pathway that can be utilized to produce an indium-based photoresist in accordance with examples herein.
FIG. 10 illustrates another example synthetic pathway that can be utilized to produce an indium-based photoresist in accordance with examples herein.
FIG. 11 illustrates another example synthetic pathway that can be utilized to produce an indium-based photoresist in accordance with examples herein.
FIG. 12 illustrates example alkyl substitution patterns for amide ligands that may be included in the example synthetic pathways of FIGS. 4-11.
FIG. 13 illustrates additional alkyl substitution patterns for ligands that may be included in the example synthetic pathways of FIG. 4-11.
FIG. 14 illustrates an example monodentate ligand that can be included in the example indium-based photoresists disclosed herein.
FIG. 15 illustrates example bidentate ligands that can be included in the example indium-based photoresists disclosed herein.
FIG. 16 illustrates example tridentate ligands that can be included in the example indium-based photoresists disclosed herein.
FIG. 17 illustrates an example molecular structure of the monodentate ligand of FIG. 14.
FIG. 18 illustrates an example molecular structure of one of the bidentate ligands of FIG. 15.
FIG. 19 illustrates an example molecular structure of another one of the bidentate ligands of FIG. 15.
FIG. 20 illustrates an example molecular structure of another one of the bidentate ligands of FIG. 15.
FIG. 21 illustrates an example molecular structure of one of the tridentate ligands of FIG. 16.
FIG. 22 illustrates an example molecular structure of another one of the tridentate ligands of FIG. 16.
FIG. 23 illustrates example molecular structures associated with example indium-based photoresists.
FIGS. 24 is a flowchart illustrating an example method of manufacturing any of the example indium-based photoresists disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

In extreme ultraviolet lithography (EUVL), a photoresist on a substrate is exposed to light that has extreme ultraviolet (EUV) wavelengths near 13.5 nanometers (nm) in predefined areas (e.g., particular shapes) to produce a pattern on the substrate. More particularly, the photoresist is a light-sensitive material that is coated on the substrate, and a patterned mask is used to enable a pattern of light (e.g., extreme ultraviolet (EUV) light) to be shone on the photoresist layer. In some examples, the EUV light is directed towards the mask in which portions of the mask (defined by the pattern of a light-absorbing material on the mask) absorb the light while other portions of the mask reflect the light towards the photoresist layer. A pattern of the reflective portions of the mask (e.g., the portions between the light-absorbing material on the mask) corresponds with and/or defines the areas of the photoresist to be exposed to the light. After the predefined area of the photoresist is exposed to light and any necessary post exposure bakes are completed, a developer (e.g., a solvent) is then applied to (e.g., positioned on) the photoresist. In the case of a positive photoresist, the light-sensitive material is degraded by the light and the developer dissolves away the portion of the photoresist that was exposed to the light. As such, the developer produces a positive photoresist pattern that matches the pattern (e.g., shape) of the light-absorbing material on the mask. In the case of a negative photoresist, the photosensitive material is strengthened (e.g., polymerized, or cross-linked) by the light, and the developer dissolves away the portion(s) of the photoresist that was not exposed to the EUV light. Thus, the developer produces a negative photoresist pattern that matches the reflective portions of the mask (e.g., is the inverse of the pattern of the light-absorbing material on the mask).

Known photoresists are typically based on tin (e.g., tin-oxide materials). Such tin-based materials have been the standard for photoresists utilized in EUVL. However, tin-based materials lack stability as a result of their sensitivity to ambient environmental constituents. Specifically, the strength and reactivity profile of bonds in the tin-based (e.g., tin-oxide) materials results in their uptake of carbon dioxide, water, and other small molecules, which inhibit EUVL photochemistry and presents challenges for high volume manufacturing (HVM) implementations. As such, certain tin-based materials for photoresists are too unstable for some manufacturing processes. That is, the relatively high sensitivity to ambient environmental constituents in a manufacturing environment can cause the tin-based materials to become contaminated and/or encounter deleterious reactivity between the time that the photoresist is deposited on the substrate and the time that the photoresist is exposed to light. Additionally, the relatively low solubility of tin-based photoresists limits a thickness to which the photoresist can be reduced, which can cause the package to become too big for EUVL manufacturing.

Examples disclosed herein include indium-based photoresists (e.g., photoresists that include indium-oxide materials) for use in integrated circuit (IC) (e.g., semiconductor) manufacturing. The indium-based materials disclosed herein provide a more advantageous reactivity profile than known photoresists. Additionally, the indium-based materials have stronger metal-oxygen bonds and metal-alkyl bonds than known photoresists, which further increases the stability of the indium-based materials. As a result, the indium-based photoresists disclosed herein take up less carbon dioxide, water, and other small molecules than the tin-based photoresists.

More particularly, the example indium-based photoresists disclosed herein include indium-based molecular clusters, which can be deposited on a substrate layer to be included in an IC package. For example, the indium-based molecular clusters can be deposited on the substrate layer in the vapor phase by chemical vapor deposition and/or atomic layer deposition. Additionally or alternatively, the indium-based molecular clusters can be deposited as part of a solution as a castable material in an organic casting solvent that provides appropriate solubility (e.g., via spin coating). In some examples, when depositing the indium-based molecular clusters via chemical vapor deposition and/or atomic layer deposition, an indium vapor deposition precursor is deposited on the substrate layer in parallel (e.g., co-flows) with another reactant, such as water, which improves a uniformity in the thickness of the photoresist layer. The reduced thickness deviation enables the thickness of the photoresist layer to be controlled with greater precision. As such, an indium-based photoresist layer can be less than approximately 10 nm thick.

As used herein, a molecular cluster (or "cluster" for short) is a molecule that includes more than two metal atoms that are bonded to both an oxygen atom and a stabilizing ligand. In general, molecular clusters are held together by relatively weak intermolecular forces or chemical bonds and their properties can vary based on, for example, a type and/or number of constituent molecules, an arrangement of the molecules within the cluster, and/or external conditions (e.g., pressure, temperature, environmental constituents, etc.). The more than two metal atoms in example molecular clusters disclosed herein include indium. Indium-based molecular clusters have stronger metal-oxygen bonds and metal-alkyl bonds than the tin-based molecular clusters currently used as photoresists. As a result, the indium-based molecular clusters are more stable than the tin-based molecular clusters. Additionally, the reactivity profile of bonds to indium is an improvement relative to the reactivity profile of bonds tin. The relative increase in stability, and the improved reactivity profile reduces (e.g., minimizes) issues that may arise from exposure to atmospheric constituents, is beneficial for a photoresist. Tin-based molecular clusters may encounter deleterious reactivity during the time between deposition of the photoresist and when it is exposed to light, while the stability and reactivity profile of indium-based molecular clusters enables the indium-based photoresists to encounter reduced deleterious reactivity relative to the tin-based photoresists. For example, the indium-based photoresist can reduce (e.g., avoid) the effects of deleterious activity that tin-based photoresists encounter from atmospheric constituents, such as water, carbon-dioxide, and/or other molecules that the photoresist is exposed to between deposition and exposure to light/patterning.

Additionally, example indium-based photoresists disclosed herein provide increased stability with respect to hydrolysis of the indium-alkyl bond when compared to tin-alkyl bonds, which readily react with water under ambient conditions as well as under vapor deposition conditions. Advantageously, example indium-based photoresists disclosed herein include large carbon impurities. In some examples, the example indium-based photoresists include a carbon content between 10 atomic percent (at. %) and 40 at. %. In some examples, the indium-based photoresists include a carbon content of at least 1 at. %. As a result, the incorporation of carbon containing groups can provide the necessary reaction pathways needed under EUV irradiation and high numerical aperture (NA) EUV patterning conditions to yield crosslinking and access negative tone resists. Additionally, the large carbon impurities can be beneficial in increasing long term solution stability.

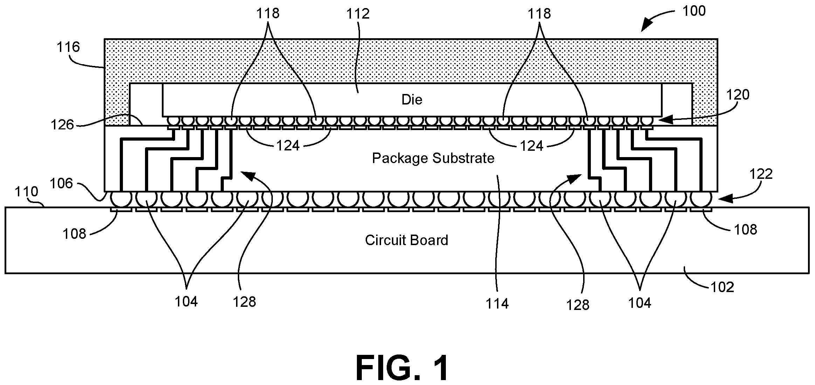

FIG. 1 illustrates an example integrated circuit (IC) package 100 constructed in accordance with teachings disclosed herein. In the illustrated example, the IC package 100 is electrically coupled to a circuit board 102 via an array of bumps or balls 104 (e.g., a ball grid array (BGA)) that protrude from a mounting surface (e.g., an external surface) 106 of the package 100. In this example, the bumps 104 are electrically coupled to corresponding contacts or landing pads 108 on a facing mounting surface (e.g., a top surface) 110 of the circuit board 102. In this example, the landing pads 108 are flush with the top surface 110 of the circuit board 102. In other examples, the landing pads 108 are inset relative to the top surface 110. In other examples, the landing pads 108 protrude beyond the top surface 110. In this example, the package 100 includes a semiconductor (e.g., silicon) die 112 that is mounted to a package substrate 114 and enclosed by a package lid or mold compound 116. While the example IC package 100 of FIG. 1 includes a single die 112, in other examples, the package 100 may have more than one die (e.g., two or more positioned side-by-side on the package substrate 114 and/or two or more stacked on top of one another). The die 112 can provide any suitable type of functionality (e.g., data processing, memory storage, etc.).

As shown in the illustrated example, the die 112 is electrically and mechanically coupled to the package substrate 114 via a corresponding array of bumps or balls 118. The electrical connections between the die 112 and the package substrate 114 (e.g., the bumps 118) are sometimes referred to as first level interconnects 120. By contrast, the electrical connections between the IC package 100 and the circuit board 102 (e.g., the bumps 104) are sometimes referred to as second level interconnects 122. In some examples, when more than one die is included in the package 100, the dies may be stacked on top of one or more other dies and/or an interposer. In such examples, the dies are coupled to the underlying die and/or interposer through a first set of first level interconnects and the underlying die and/or interposer may be connected to the package substrate 114 via a separate set of first level interconnects associated with the underlying die and/or interposer. Thus, as used herein, first level interconnects refer to bumps or balls or other types of interconnects between a die and a package substrate or a die and an underlying die and/or interposer.

As shown in FIG. 1, the bumps 118 of the first level interconnects 120 are physically connected and electrically coupled to contact pads 124 on an inner surface 126 of the substrate 114. For purposes of illustration, the contact pads 124 are shown to be flush with the inner surface 126 of the substrate 114. However, in some examples, the contact pads 124 are inset relative to the inner surface 126. Specifically, in some such examples, the inner surface 126 is defined by a solder resist that includes openings to expose corresponding ones of the contact pads 124. The contact pads 124 along on the inner surface 126 of the package substrate 114 are electrically coupled to the bumps 104 on the bottom (external) surface 106 of the substrate 114 (e.g., a surface opposite the inner surface 126) via internal interconnects 128 within the substrate 114. As a result, there is a complete signal path between the bumps 118 of the die 112 and the landing pads 108 on the circuit board 102 that pass through the contact pads 124, the interconnects 128, and the bumps 104 provided therebetween. The interconnects 128 are shown as simple lines in the illustrated example of FIG. 1 for purposes of illustration. However, the internal interconnects 128 may be implemented by traces or electrical routing in different metal layers within the substrate 114 that are separated by layers of dielectric material. The traces in the different metal layers are electrically coupled by metal vias extending through the layers of dielectric material.

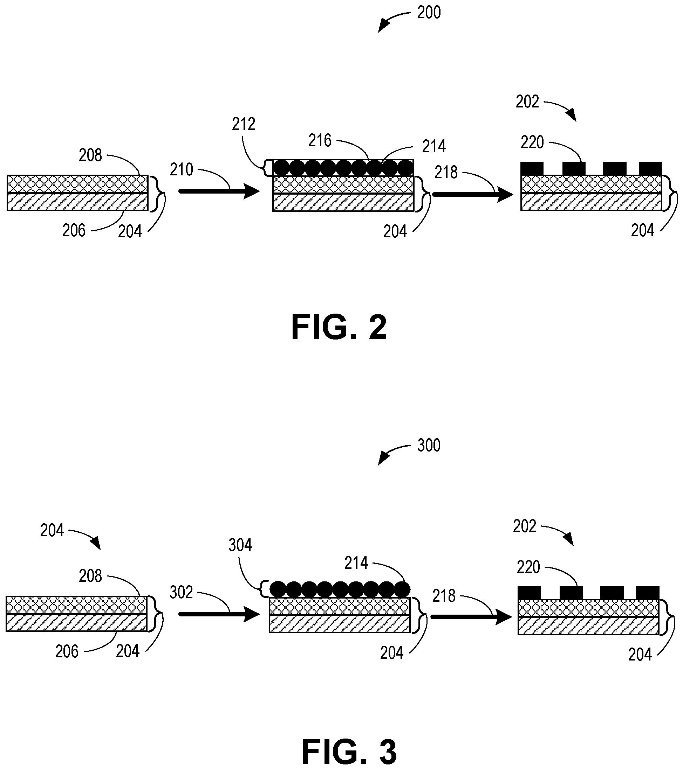

FIG. 2 illustrates an example process 200 to produce a patterned substrate 202. The example process 200 of FIG. 2 can be utilized to produce patterned materials in the IC package 100 of FIG. 1. For example, the process 200 can be utilized to pattern a solder resist on the inner surface 126 of the package substrate 114 of FIG. 1. Alternatively, the process 200 may be used to pattern materials in the die 112 of FIG. 1 or another layer within the package substrate 114.

In the illustrated example of FIG. 2, a substrate 204 (e.g., a substrate layer that is to be included in the IC package 100 of FIG. 1) includes a first substrate layer 206 and a second substrate layer 208 positioned on the first substrate layer 206. For example, the first substrate layer 206 can include silicon and oxygen (e.g., silicon dioxide (SiO₂)). Further, the second substrate layer 208 is an underlayer (e.g., a layer to be directly under a photoresist to be applied), which can include a conductive material (e.g., copper). In other examples, the underlayer can be any other suitable material.

During a chemical vapor deposition or atomic layer deposition manufacturing operation 210, an indium-based precursor and another reactant (e.g., a coreactant), such as water, hydrogen peroxide, an alcohol, or a carboxylic acid are co-flowed into a reaction chamber that includes the first substrate layer 206 and the second substrate layer 208. In this example, the coreactant that reacts with the indium-based precursor during the chemical vapor deposition or atomic layer deposition manufacturing operation 210 is in a vapor phase. The chemical vapor deposition or atomic layer deposition operation 210 produces a photoresist 212 including indium oxide-based (e.g., indium-oxy-carbide) clusters 214 that are synthesized in a solution or vapor phase that produces a film 216 of the clusters 214 positioned on the substrate 204. The indium oxide-based clusters 214 may be ionic in nature and held together by counter ions. In some examples, a byproduct of the chemical vapor deposition or atomic layer deposition manufacturing operation 210 includes hydrogen, nitrogen, and a carbon-based organic (e.g., an alkane or alkene, etc.), which are transported away from the substrate 204. Example indium-based precursors to be utilized in the chemical vapor deposition or atomic layer deposition manufacturing operation 210 for the production of the photoresist 212 are discussed in further detail below.

During a patterning and development operation 218, a photomask is employed to expose the photoresist 212 to light (e.g., EUV light waves) that has a particular pattern defined by the photomask. After exposure to the patterned light, a developer is then applied to the photoresist 212 to weaken and remove the exposed portion(s) of the photoresist 212 (e.g., when indium oxide-based clusters 214 form a positive photoresist) or weaken and remove the portion(s) of the photoresist 212 not exposed to the light (e.g., when the indium oxide-based clusters 214 form a negative photoresist). After the patterning and development operation 218, a pattern of cross-linked indium oxide-based clusters 220 are positioned on the substrate layer 204 to form the patterned substrate 202. More particularly, in some examples, the exposure of the indium oxide-based clusters 220 to light causes the indium oxide-based clusters 220 to cross-link. In some examples, the indium oxide-based clusters are cross-linked during production of the indium oxide-based clusters 220 (e.g., during the chemical vapor deposition or atomic layer deposition manufacturing operation 210) and are broken apart during exposure to light. The patterned substrate 202 can then undergo further manufacturing to form the IC package 100 of FIG. 1. For instance, in some examples, the patterned photoresist 212 (e.g., the pattern of cross-linked indium oxide-based clusters 220) serves as a mask to etch the underlying second substrate layer 208 in the regions exposed through the openings in the photoresist 212. In some examples, the openings may be filled with a material to be added onto the underlying second substrate layer 208 according to the pattern defined by the openings.

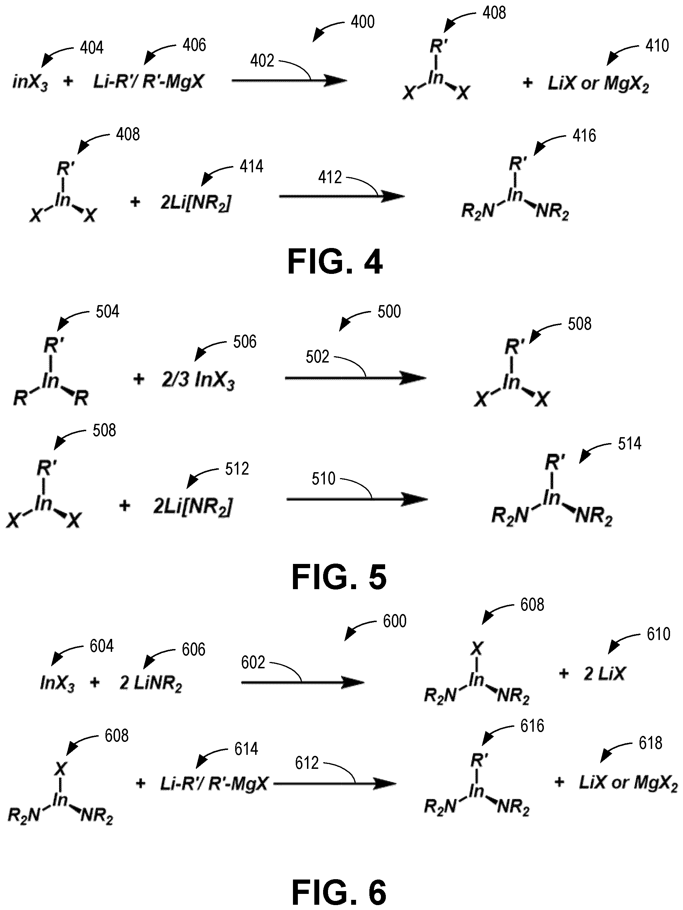

FIG. 3 illustrates another example process 300 to produce the patterned substrate 202. Similar to the process 200 of FIG. 2, the process 300 of FIG. 3 begins with the substrate 204 including the first substrate layer 206 and the second substrate layer 208. In the process 300 of FIG. 3, during a spin coating operation 302, a photoresist 304 including a solution-phase form of the indium oxide-based clusters 214 is positioned on the substrate 204, and the substrate 204 is spun to distribute the indium oxide-based clusters 214 across a surface of the substrate 204. In this example, an indium-based precursor reacts with a coreactant, such as water, hydrogen peroxide, an alcohol, or a carboxylic acid, that is a solvent. Example indium-based precursors to be reacted with the coreactant for the production of the photoresist 304 are discussed in further detail below in connection with FIGS. 4-23. As a result, the indium oxide-based clusters 214 coat the substrate 204 as a thin film. The photoresist 304 is analogous to the indium oxide-based clusters 214 synthesized in the vapor phase of FIG. 2 but is deposited via spin coating (e.g., without having to produce the film 216 through a vapor deposition process, though the clusters 214 may still be synthesized in the vapor phase, but can also be synthesized in a solution). The photoresist 304 and the substrate 204 then undergo the patterning and development operation 218, as discussed above in association with FIG. 2, to produce the pattern of cross-linked indium oxide-based clusters 220 on the substrate 204.

FIGS. 4-11 illustrate example synthetic pathways that can be utilized to produce indium-based precursors for the production of the indium oxide-based molecular clusters 214 in the photoresists 212, 304 of FIGS. 2 and/or 3. Specifically, to produce the indium oxide-based molecular clusters using the indium-based precursors of FIGS. 4-11, the indium-based precursors are reacted with a coreactant, such as water, hydrogen peroxide, an alcohol, or a carboxylic acid. When the indium oxide-based molecular clusters 214 are to be applied to the substrate 204 via the spin coating operation 302, the coreactant is a solvent. When the indium oxide-based molecular clusters 214 are to be applied to the substrate 204 via the chemical vapor deposition or atomic layer deposition manufacturing operation 210, the coreactant is a vapor. In the example synthetic pathways of FIGS. 4-11, "X" corresponds to a halogen (e.g., chlorine, fluorine, bromine, iodine, etc.). Additionally, in the example synthetic pathways of the illustrated examples, "R" and "R'" correspond to an alkyl group (e.g., a carbon-based organic, a long output chain, such as ethyl, methyl, isopropyl, tributyl, etc.). Moreover, although "R" and "R'" are different representations of alkyl groups in FIGS. 4-11, in some examples, "R" and "R'" correspond to the same alkyl group. In some examples, "R" and "R'" correspond to different alkyl groups. More particularly, in some examples, "R" corresponds to alkyl groups that are bound to nitrogen, and "R'" corresponds to alkyl groups that are bound to indium.

FIG. 4 illustrates a first example synthetic pathway 400. In the example of FIG. 4, the synthetic pathway 400 includes a first reaction 402 between a first reactant 404 and a second reactant 406. The first reactant 404 includes an indium halide, such as indium trihalide. The second reactant 406 includes an equilibrium reactant or a granum reactant, such as alkyl lithium or organolithium. The first reaction 402 produces a first product 408 and a second product 410. The first product 408 includes an alkyl group bound to indium. The second product 410 includes a salt. Specifically, the first reaction 402 is a salt elimination reaction that transfers an alkyl group to indium to produce the first product 408 and also results in the generation of a salt (e.g., lithium chloride, magnesium chloride, etc.) corresponding to the second product 410.

In the example of FIG. 4, the first product 408 then undergoes a second reaction 412 with a third reactant 414. The third reactant 414 includes another salt, such as a lithium dialkylamide. The second reaction 412 is another salt elimination reaction. In this example, the second reaction 412 a transfers nitrogen containing group (e.g., an amide group) to the indium atom in the first product 408 to produce a third product 416. The third product 416 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the third product 416 can be utilized in the solution phase generation of indium-based clusters to be utilized in spin-on based resists (e.g., the spin coating operation 302 of FIG. 3) to produce the photoresist 304 of FIG. 3.

FIG. 5 illustrates a second example synthetic pathway 500. In the example of FIG. 5, the synthetic pathway 500 includes a first reaction 502 between a first reactant 504 and a second reactant 506. The first reactant 504 includes a tri-alkyl indium that has three alkyl groups. In some examples, the three alkyl groups in the first reactant 504 are the same. In some examples, two of the three alkyl groups in the first reactant 504 are the same. In some examples, each of the three alkyl groups in the first reactant 504 are different. The second reactant 506 includes an indium halide material. The first reaction 502 is a comproportionation reaction, which causes the first reactant 504 and the second reactant 506 to combine and produce a first product 508 (e.g., a single product). The first product 508 includes a mixture of the alkyl groups from the first reactant 504 and the halide groups from the second reactant 506. Specifically, the first product 508 includes two halide groups and one alkyl group bonded to indium.

In the example of FIG. 5, the first product 508 undergoes a second reaction 510 with a third reactant 512 to produce a second product 514. The third reactant 512 includes a salt, such as a lithium dialkylamide. The second reaction 510 is a salt elimination reaction. The second product 514 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the second product 514 can be utilized in the solution phase generation of indium-based clusters to be utilized in spin-on based resists (e.g., the spin coating operation 302 of FIG. 3) to produce the photoresist 304 of FIG. 3.

FIG. 6 illustrates a third example synthetic pathway 600. In the example of FIG. 6, the synthetic pathway 600 includes a first reaction 602 between a first reactant 604 and a second reactant 606. The first reactant 604 includes an indium halide, such as indium trihalide. In some examples, the first reactant 604 is the same as the first reactant 404 of FIG. 4. In some examples, the first reactant 604 includes a different halide than the first reactant 404 of FIG. 4. The second reactant 606 includes another salt, such as a lithium dialkylamide. In this example, the first reaction 602 is a salt elimination reaction that produces a first product 608 and a second product 610. In this example, the first product 608 includes one halide and two nitrogen groups bonded to the indium atom. The second product 610 includes a lithium halide such as lithium chloride.

In the example of FIG. 6, the first product 608 then undergoes a second reaction 612 with a third reactant 614. The third reactant 614 includes an equilibrium reactant or a granum reactant, such as alkyl lithium or organolithium or an alkylmagnesium halide. The second reaction 612 is another salt elimination reaction that produces a third product 616 and a fourth product 618. The fourth product 618 includes a salt. The third product 616 includes an alkyl group bound to indium. The third product 616 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the third product 616 can be utilized in the solution phase or vapor phase in the generation of indium-based clusters to be utilized in spin-on based resists (e.g., the spin coating operation 302 of FIG. 3) to produce the photoresist 304 of FIG. 3.

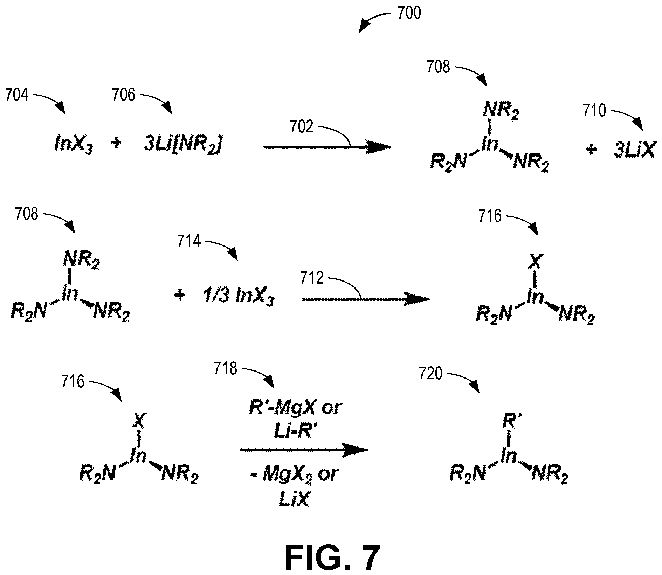

FIG. 7 illustrates a fourth example synthetic pathway 700. In the example of FIG. 7, the synthetic pathway 700 includes a first reaction 702 between a first reactant 704 and a second reactant 706. The first reactant 704 includes an indium halide, such as indium trihalide. The second reactant 706 includes a salt, such as a lithium dialkylamide. The first reaction 702 is a salt elimination reaction that fully substitutes each of the halides in the first reactant 704 with nitrogen containing groups to form a first product 708. The first product 708 includes three nitrogen containing groups bound to indium. Each of the nitrogen containing groups of the first product 708 are bound to two alkyl groups. The first reaction 702 also produces a second product 710. The second product 710 is a lithium halide such as lithium chloride.

In the example of FIG. 7, the first product 708 undergoes a second reaction 712 with a third reactant 714. The third reactant 714 includes an indium halide material. The second reaction 712 is a comproportionation reaction that causes the first product 708 to combine with the third reactant 714 to produce a third product 716. Specifically, the second reaction 712 installs a halide of the third reactant 714 on the indium of the first product 708 to produce the third product 716. As shown in FIG. 7, the third product 716 includes a halide and two nitrogen containing groups bound to the indium.

In the example of FIG. 7, the third product 716 undergoes a third reaction 718 to produce a fourth product 720. Specifically, the third reaction 720 is another salt elimination reaction that produces an alkyl-indium-carbon bond. In this example, the fourth product 720 includes one alkyl group bound to the indium, and two nitrogen containing groups bound to indium. Each of the nitrogen containing groups also contain two alkyl groups. In some examples, the alkyl group in the fourth product 720 that does not contain nitrogen is different from the alkyl groups bound to the nitrogen atoms. In some examples, the three alkyl groups in the fourth product 720 are the same. The fourth product 720 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the fourth product 720 can be utilized in the solution phase generation of indium-based clusters to be utilized in spin-on based resists (e.g., the spin coating operation 302 of FIG. 3) to produce the photoresist 304 of FIG. 3.

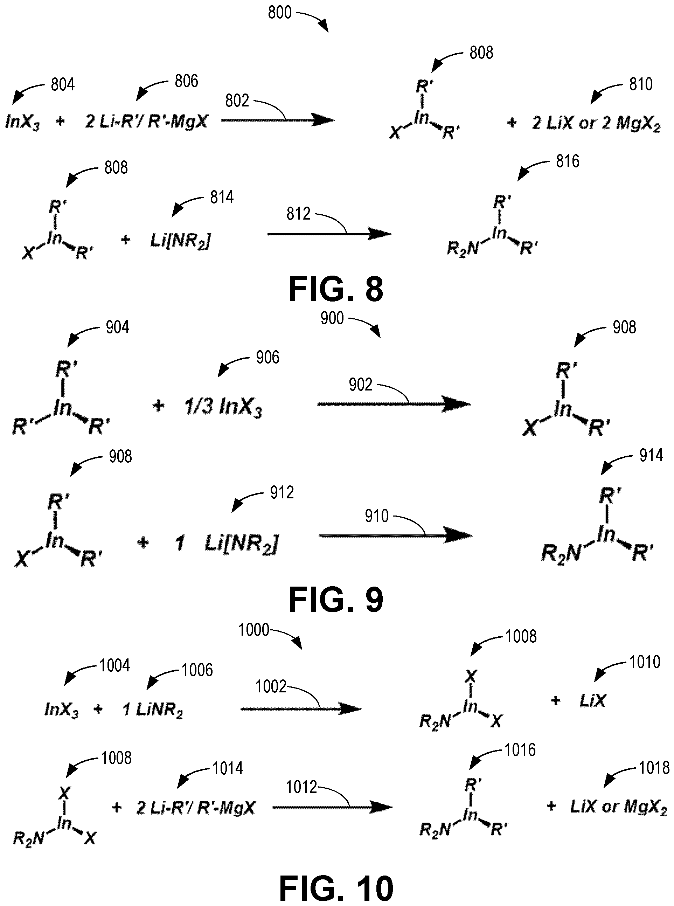

FIG. 8 illustrates a fifth example synthetic pathway 800. In the example of FIG. 8, the fifth example synthetic pathway 800 includes a first reaction 802 between a first reactant 804 and a second reactant 806. The first reactant 804 includes an indium halide, such as indium trihalide. The second reactant 806 includes an equilibrium reactant or a granum reactant, such as alkyl lithium or organolithium or an alkylmagnesium halide. More particularly, the second reactant 806 includes an alkyl group. The first reaction 802 is a salt elimination reaction that produces a first product 808 and a second product 810. The first product 808 includes two alkyl groups and a halogen bound to indium. Specifically, the first reaction 802 transfers the two alkyl groups of the second reactant 806 to the indium of the first reactant 804 to produce the first product 808. The second product 810 includes a salt (e.g., lithium chloride, magnesium chloride, etc.).

In the example of FIG. 8, the first product 808 undergoes a second reaction 812 with a third reactant 814. The third reactant 814 includes another salt, such as a lithium dialkylamide. The second reaction 812 is a comproportionation reaction that produces a third product 816, which replaces the halogen bound to indium in the first product 808 with a nitrogen atom bound to two alkyl groups. As shown in FIG. 8, the third product 816 includes two alkyl groups bound to indium and one nitrogen atom bound to indium with two alkyl groups bound to a nitrogen atom. The third product 816 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the third product 816 can be utilized in the solution phase generation of indium-based clusters to be utilized in spin-on based resists (e.g., the spin coating operation 302 of FIG. 3) to produce the photoresist 304 of FIG. 3.

FIG. 9 illustrates a sixth example synthetic pathway 900. In the example of FIG. 9, the sixth example synthetic pathway 900 includes a first reaction 902 between a first reactant 904 and a second reactant 906. The first reactant 904 includes a tri-alkyl indium that has three alkyl groups. The second reactant 906 includes a halide material. The first reaction 902 is a comproportionation reaction that produces a first product 908. The first product 908 includes two alkyl groups from the first reactant 904 and a halide group from the second reactant 906.

In the example of FIG. 9, the first product 908 undergoes a second reaction 910 with a third reactant 912 to produce a second product 914. The third reactant 912 includes a salt, such as a lithium dialkylamide. The second reaction 910 is a salt elimination reaction. The second product 914 includes two alkyl groups bound to indium with one nitrogen atom bound to indium with two alkyl groups bound to the nitrogen atom. The second product 914 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the second product 914 can be utilized in the solution phase generation of indium-based clusters to be utilized in spin-on based resists (e.g., the spin coating operation 302 of FIG. 3) to produce the photoresist 304 of FIG. 3.

FIG. 10 illustrates a seventh example synthetic pathway 1000. In the example of FIG. 10, the synthetic pathway 1000 includes a first reaction 1002 between a first reactant 1004 and a second reactant 1006. The first reactant 1004 includes an indium halide, such as indium trihalide. In some examples, the first reactant 1004 is the same as the first reactant 404 of FIG. 4 and/or the first reactant 604 of FIG. 6. In some examples, the first reactant 1004 includes a different halide than the first reactant 404 of FIG. 4 and/or the first reactant 604 of FIG. 6. The second reactant 1006 includes a salt, such as a lithium dialkylamide. The first reaction 1002 is a salt elimination reaction that produces a first product 1008 and a second product 1010. The first product 1008 includes two halides bound to indium and a nitrogen bound to indium with two alkyl groups bound to a nitrogen atom. The second product 1010 includes lithium chloride.

In the example of FIG. 10, the first product 1008 undergoes a second reaction 1012 with a third reactant 1014. The third reactant 1014 includes an equilibrium reactant or a granum reactant, such as alkyl lithium or organolithium or an alkylmagnesium halide. The second reaction 1012 is another salt elimination reaction that produces a third product 1016 and a fourth product 1018. The third product 1016 includes two alkyl groups bound to indium with one nitrogen atom bound to indium with two alkyl groups bound to the nitrogen atom. The fourth product 1018 includes a salt. Specifically, the second reaction 1012 causes two alkyl groups of the third reactant 1014 to bind to the indium of the first product 1008 in place of the two halides. The third product 1016 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the third product 1016 can be utilized in the solution phase generation of indium-based clusters to be utilized in spin-on based resists (e.g., the spin coating operation 302 of FIG. 3) to produce the photoresist 304 of FIG. 3.

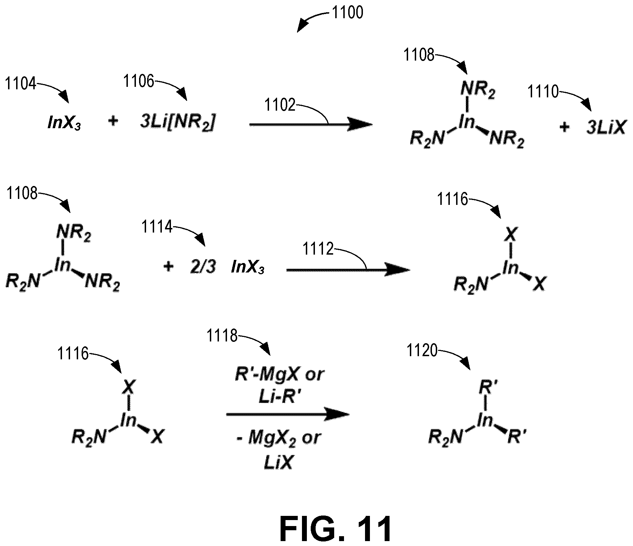

FIG. 11 illustrates an eighth example synthetic pathway 1100. In the example of FIG. 11, the synthetic pathway 1100 includes a first reaction 1102 between a first reactant 1104 and a second reactant 1106. The first reactant 1104 includes an indium halide, such as indium trihalide (e.g., indium trichloride). The second reactant 1106 includes a salt, such as a lithium dialkylamide. The first reaction 1102 is a salt elimination reaction that fully substitutes each of the halides in the first reactant 1104 with nitrogen containing groups to form a first product 1108. The first product 1108 includes three nitrogen containing groups bound to indium. Each of the nitrogen containing groups of the first product 1108 are bound to two alkyl groups. The first reaction 1102 also produces a second product 1110. The second product 1110 includes a lithium halide (e.g., lithium chloride).

In the example of FIG. 11, the first product 1108 undergoes a second reaction 1112 with a third reactant 1114. The third reactant includes another indium halide. The second reaction 1112 is a comproportionation reaction that causes two halides to replace two of the nitrogen containing groups in the first product 1108, which produces a third product 1116. In this example, the third product 1116 includes two halide groups bound to indium and a nitrogen containing group bound to indium. As mentioned above, the nitrogen containing group is also bound to two alkyl groups.

In the example of FIG. 11, the third product 1116 undergoes a third reaction 1118 to produce a fourth product 1120. Specifically, the third reaction 1118 is another salt elimination reaction that produces an alkyl-indium bond. In this example, the fourth product 1120 includes two alkyl groups bound to the indium, and one nitrogen atom bound to indium with two alkyl groups bound to the nitrogen atom. In some examples, the carbon containing group in the fourth product 1120 that does not contain nitrogen is different from the carbon containing groups bound to the nitrogen atom. In some examples, all the alkyl groups in the fourth product 1120 are the same. The fourth product 1120 includes an example indium-based precursor that can be utilized in chemical and atomic layer vapor deposition processes (e.g., in the chemical vapor deposition or atomic layer deposition manufacturing operation 210) to produce the photoresist 212 of FIG. 2. Additionally or alternatively, the fourth product 1120 can be utilized in the solution phase generation of indium-based clusters to be utilized in spin-on based resists (e.g., the spin coating operation 302 of FIG. 3) to produce the photoresist 304 of FIG. 3.

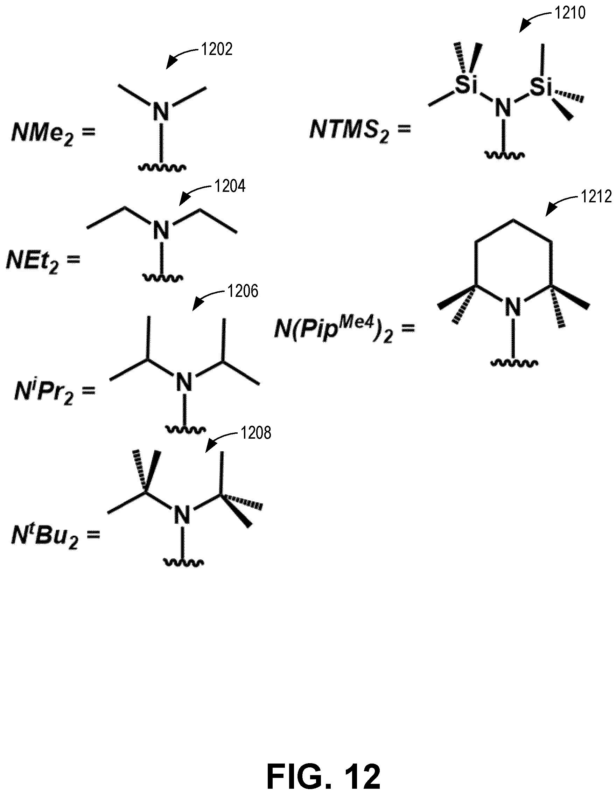

FIG. 12 illustrates example alkyl substitution patterns for amide ligands that may be included in the synthetic pathways 400, 500, 600, 700, 800, 900, 1000, 1100 of FIGS. 4-11. More particularly, the amide ligands of FIG. 12 are representative of example implementations of organosilylsubstituents bound to nitrogen in FIGS. 4-11. Accordingly, the photoresists 212, 304 and/or the example indium-based precursors 416, 514, 616, 720, 816, 914, 1016, 1120 disclosed herein can include the amide ligands of FIG. 12. In FIG. 12 and throughout all chemical structures depicted in the figures, a squiggly or wavy line in the chemical structure is indicative of where the ligand is bound to indium. In the illustrated example of FIG. 12, the organosilylsubstituents include dimethylamine 1202, diethylamine 1204, diisopropylamine 1206, ditert-butylamine 1208, a bis(trimethylsilyl)amine 1210, and a tetramethylpiperidine 1212.

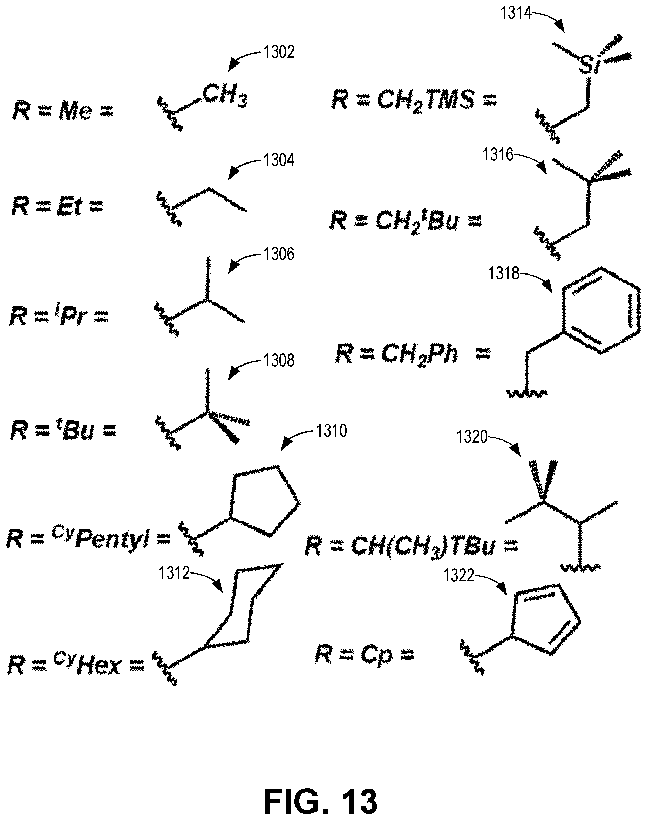

FIG. 13 illustrates additional alkyl substitution patterns for ligands that may be included in the synthetic pathways 400, 500, 600, 700, 800, 900, 1000, 1100 of FIGS. 4-11. More particularly, the ligands of FIG. 13 are representative of example implementations of the alkyl groups (R') bound to indium in FIGS. 4-11. Accordingly, the photoresists 212, 304 and/or the example indium-based precursors 416, 514, 616, 720, 816, 914, 1016, 1120 disclosed herein can include the ligands of FIG. 13. In the illustrated example of FIG. 13, the alkyl groups include a methyl group 1302, an ethyl group 1304, an isopropyl group 1306, a tert-butyl group 1308, a cyclopentyl group 1310, a cyclohexyl group 1312, a methylene group connected to a trimethylsilyl 1314, a methylene group connected to a tert-butyl group 1316, a methylene group connected to a phenyl group 1318, a methylene group attached to both a methyl group and a tert-butyl group 1320, and a cyclopentadienyl ligand 1322.

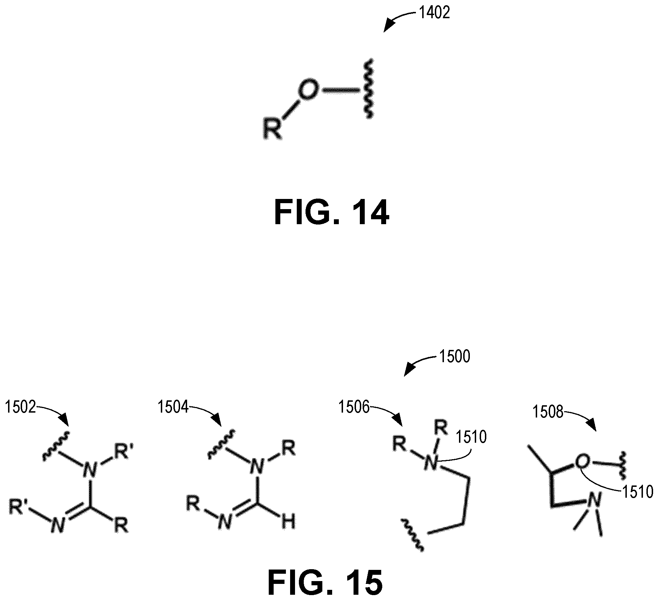

FIG. 14 illustrates an example monodentate ligand 1402 that can be bound to indium. The photoresists 212, 304 and/or the example indium-based precursors 416, 514, 616, 720, 816, 914, 1016, 1120 disclosed herein can include the monodentate ligand 1402 of FIG. 14. Specifically, the monodentate ligand 1402 is bound to indium in one location. The monodentate ligand 1402 is an alkoxide, which is an alcohol-based ligand that enables tuning of a vapor phase reactivity of the photoresist 212, 304 and/or the precursor 416, 514, 616, 720, 816, 914, 1016, 1120.

FIG. 15 illustrates example bidentate ligands 1500 that can be bound to indium. Specifically, the bidentate ligands 1500 of FIG. 15 can bind to indium in two locations. As such, the bidentate ligands 1500 can provide increased stability towards complex organometallic or inorganic complexes by binding to indium in more than one location. As a result, the bidentate ligands 1500 enable tuning of the volatility of the photoresist 212, 304 and/or the precursor 416, 514, 616, 720, 816, 914, 1016, 1120. The bidentate ligands 1500 include a first bidentate ligand 1502 (e.g., an amidinate), a second bidentate ligand 1504 (e.g., a formamidinate), a third bidentate ligand 1506 (e.g., an alkylamine), and a fourth bidentate ligand 1508 (e.g., an amino alkoxide). The third bidentate ligand 1506 and the fourth bidentate ligand 1508 include a pendant amine 1510, which allows the nitrogen and/or oxygen to flexibly and reversibly bind to the indium. As such, the pendant amine 1510 can provide initial stability while also providing the ability to disconnect from the indium under reaction conditions.

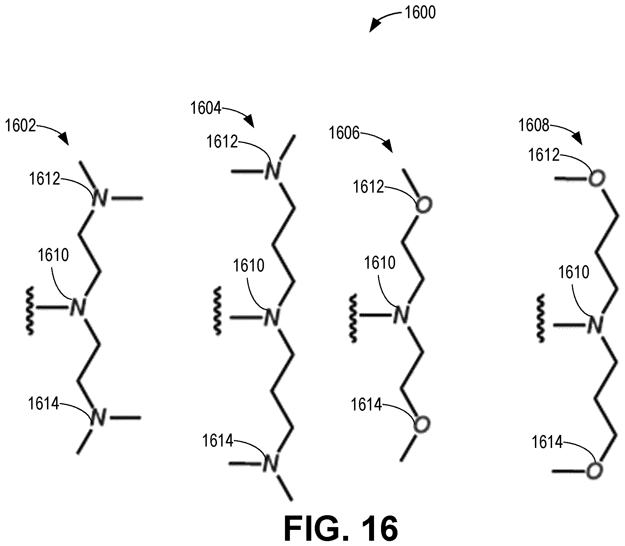

FIG. 16 illustrates example tridentate ligands 1600 that can be bound to indium. Specifically, the tridentate ligands 1600 of FIG. 16 can bind to indium in up to three locations to enable tuning of the volatility of the photoresist 212, 304 and/or the precursor 416, 514, 616, 720, 816, 914, 1016, 1120. The tridentate ligands 1600 include a first tridentate ligand 1602 (e.g., a bis(dimethylaminoethyl)amide), a second tridentate ligand 1604 (e.g., a bis(dimethylaminopropyl)amide), a third tridentate ligand 1606 (e.g., a di(methyoxyethyl)amide), and a fourth tridentate ligand 1608 (e.g., a di(methyoxypropyl)amide). The tridentate ligands 1602, 1604, 1606, 1608 are pincer-type ligands. In the tridentate ligands 1600, a central nitrogen 1610 is strongly bound to the indium. The tridentate ligands 1600 also include two pendant amines 1612, 1614 to further increase the stability of the photoresist 212, 304 and/or the precursor 416, 514, 616, 720, 816, 914, 1016, 1120. In some examples, the photoresist 212, 304 and/or the precursor 416, 514, 616, 720, 816, 914, 1016, 1120 includes a derivative of the tridentate ligands 1600 of FIG. 16 where the nitrogen and/or oxygen atoms are substituted out for a different atom in the p-block of the periodic table (e.g., carbon).

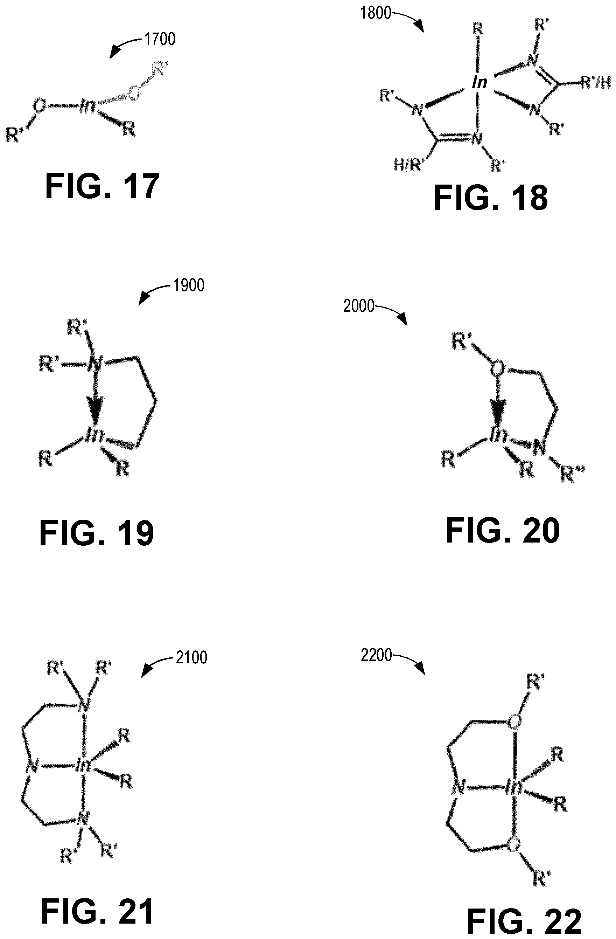

FIG. 17 illustrates an example molecular structure 1700 of the monodentate ligand 1402 of FIG. 14. FIG. 18 illustrates an example molecular structure 1800 of the first bidentate ligand 1502 and/or the second bidentate ligand 1504 of FIG. 15. FIG. 19 illustrates an example molecular structure of the third bidentate ligand 1506 of FIG. 15. FIG. 20 illustrates an example molecular structure of the fourth bidentate ligand 1508 of FIG. 15. FIG. 21 illustrates an example molecular structure 2100 of the first tridentate ligand 1602 and/or the second tridentate ligand 1604 of FIG. 16. FIG. 22 illustrates an example molecular structure 2200 of the third tridentate ligand 1606 and/or the fourth tridentate ligand 1608 of FIG. 16.

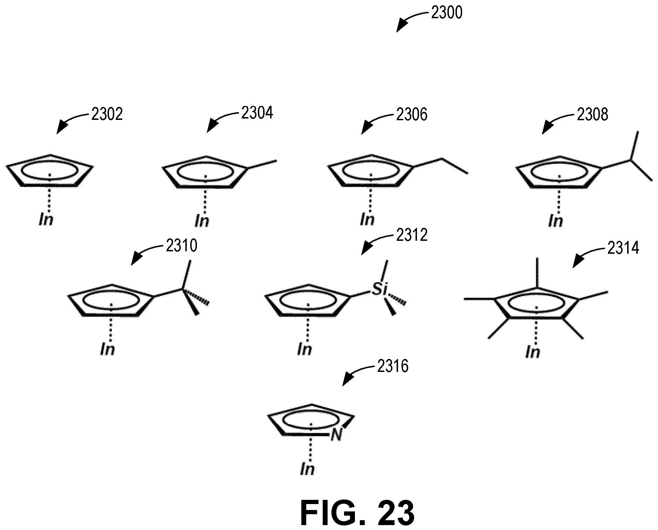

The indium-based precursors 416, 514, 616, 720, 816, 914, 1016, 1120, 1402, 1502, 1504, 1506, 1508, 1602, 1604, 1606, 1608 of FIGS. 4-11 and 14-22 are in a +3 oxidation state. FIG. 23 illustrates example indium precursors 2300 in a +1 oxidation state. The indium precursors 2300 of FIG. 23 include different ligand classes that provide a different reactivity profile than the indium-based precursors 416, 514, 616, 720, 816, 914, 1016, 1120, 1402, 1502, 1504, 1506, 1508, 1602, 1604, 1606, 1608 of FIGS. 4-11 and 14-22. The indium precursors 2300 of FIG. 23 include cyclopentadienyl (Cp) ligands. The indium precursors 2300 are able to utilize the η⁵-binding mode which allows for up to a total of 5 bonds between the indium atom and the stabilizing ligand. Additionally, because of the different oxidation state and the reduced amount of organic matter surrounding the metal center, the indium precursors 2300 enable utilization of non-oxidizing agents to change structure and/or composition of the indium precursors 2300. For example, the indium precursors 2300 can provide an indium-carbide film to be coated on a substrate (e.g., the package substrate 114 of FIG. 1, the substrate 204 of FIGS. 2 and 3) without reacting with water or another hydrogen-containing material. As such, the indium precursors 2300 avoid issues that may be caused by water or protic reagents being sluggish. Additionally, the indium precursors of FIG. 23 can enable tuning of properties of the resulting photoresist film through incorporation of additional alkyl groups via oxidation with organic peroxides. Further, tin-based materials (used in known photoresists) are not capable of a +1 to +3 reduction-oxidation such that the advantages provided by the indium precursors 2300 of FIG. 23 are distinct from tin-based materials. The indium precursors 2300 of FIG. 23 include cyclopentadienylindium 2302, methylcyclopentadienylindium 2304, ethylcyclopentadienylindium 2306, isopropylcyclopentadienylindium 2308, tert-butylcyclopentadienylindium 2310, trimethylsilylcyclopentadienylindium 2312, pentamethylcyclopentadienylindium 2314 (Cp*), and pyrrolidine 2316.

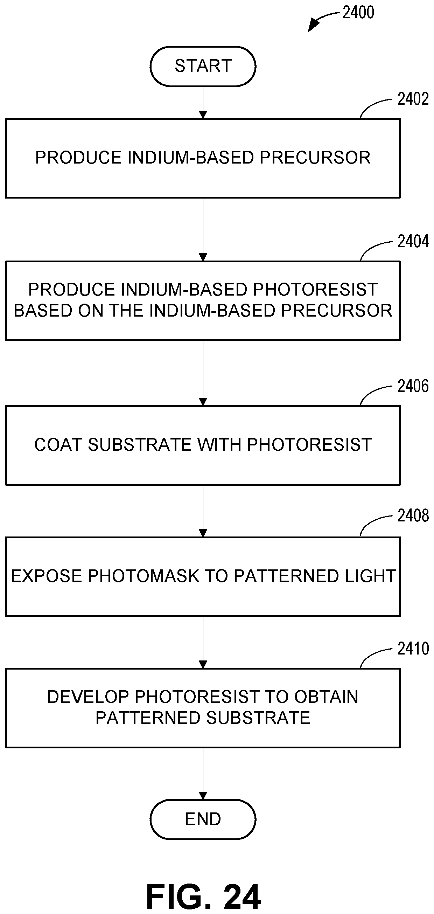

FIG. 24 is a flowchart illustrating an example method of manufacturing the patterned substrate 204 of FIGS. 2 and/or 3. In some examples, some or all of the operations outlined in the example method are performed automatically by fabrication equipment that is programmed to perform the operations. Although the example method of manufacture is described with reference to the flowchart illustrated in FIG. 24, many other methods may alternatively be used. For example, the order of execution of the blocks may be changed, and/or some of the blocks described may be combined, divided, re-arranged, omitted, eliminated, and/or implemented in any other way.

The example method 2400 of FIG. 24 begins at block 2402 by producing an indium-based precursor. For example, the indium-based precursor can be produced through a comproportionation reaction and/or one or more salt elimination reactions, as discussed in association with the synthetic pathways 400, 500, 600, 700, 800, 900, 1000, 1100 of FIGS. 4-11. The indium-based precursor can include the third product 416 of FIG. 4, the second product 514 of FIG. 5, the third product 616 of FIG. 6, the fourth product 720 of FIG. 7, the third product 816 of FIG. 8, the second product 914 of FIG. 9, the third product 1016 of FIG. 10, and/or the fourth product 1120 of FIG. 11. In some examples, the indium-based precursor includes an organosilylsubstituent that includes the dimethylamine 1202, the diethylamine 1204, the N-isopropyl-N-isopropylamine 1206, the N-tert-butyl-N-tert-butylamine 1208, the bis(trimethylsilyl)amine 1210, and/or the tetramethylpiperidine 1212 of FIG. 12. In some examples, the indium-based precursor includes an alkyl group that includes the methyl group 1302, the ethyl group 1304, the isopropyl group 1306, the tert-butyl group 1308, the cyclopentyl group 1310, the cyclohexyl group 1312, the methylene group connected to the trimethylsilyl 1314, the methylene group connected to the tert-butyl group 1316, the methylene group connected to the phenyl group 1318, the methylene group attached to both the methyl group and the tert-butyl group 1320, and/or the cyclopentadienyl ligand 1322 of FIG. 13. In some examples, the indium-based precursor includes the monodentate ligand 1402 of FIG. 14, the bidentate ligands 1500 of FIG. 15, and/or the tridentate ligands 1600 of FIG. 16. For example, the indium-based precursor can include the molecular structure 1700 of FIG. 17, the molecular structure 1800 of FIG. 18, the molecular structure 1900 of FIG. 19, the molecular structure 2000 of FIG. 20, the molecular structure of FIG. 21, and/or the molecular structure of FIG. 22. In some examples, the indium-based precursor includes the cyclopentadienylindium 2302, the methylcyclopentadienylindium 2304, the ethylcyclopentadienylindium 2306, the isopropylcyclopentadienylindium 2308, the tert-butylcyclopentadienylindium 2310, the trimethylcyclopentadienylindium 2312, the pentamethylcyclopentadienylindium 2314, and/or the pyrrolidine 2316 of FIG. 23.

At block 2404, the method 2400 involves producing an indium oxide-based photoresist based on the indium-based precursor (e.g., the photoresist 212 of FIG. 2, the photoresist 304 of FIG. 3). Specifically, to produce indium oxide-based molecular clusters of the indium oxide-based photoresist, the indium-based precursors undergo a reaction with a coreactant such as water, hydrogen peroxide, an alcohol, or a carboxylic acid. In some examples, when the photoresist is to be coated on a substrate (e.g., the substrate layer 204 of FIGS. 2 and 3, the package substrate 114 of FIG. 1, the die 112 of FIG. 1, etc.) via chemical vapor deposition and/or atomic layer deposition (e.g., the chemical vapor deposition or atomic layer deposition manufacturing operation 210 of FIG. 2), the coreactant is in a vapor phase. In some examples, when the photoresist is to be coated on the substrate via spin coating (e.g., the spin coating operation 302 of FIG. 3), the coreactant is a solvent.

At block 2406, the example method 2400 involves coating a substrate (e.g., the substrate layer 204 of FIGS. 2 and 3, the package substrate 114 of FIG. 1, the die 112 of FIG. 1, etc.) with the indium-based photoresist. For example, the substrate can be coated with the indium-based photoresist via chemical vapor deposition, atomic layer deposition, and/or spin coating. At block 2408, the example method 2400 involves exposing the photoresist to patterned light (e.g., EUV light) defined by a photomask. At block 2410, the example method 2400 involves developing the photoresist to obtain a patterned substrate (e.g., the patterned substrate 202 of FIGS. 2 and/or 3).

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example indium-based photoresists and methods of producing the same have been disclosed that provide a more advantageous reactivity profile and increased stability compared to known photoresists. Example indium-based photoresists disclosed herein can be approximately 10 nm thick or thinner, which is thinner than known photoresists and, thus, enables integrated circuits produced using the indium-based photoresists to include thinner layers. As a result, the indium-based photoresists disclosed herein enable continued scaling of semiconductor devices in accordance with Moore's Law.

Methods and apparatus utilizing indium-based precursors for integrated circuit manufacturing are disclosed herein. Further examples and combinations thereof include the following:
Example 1 includes an apparatus comprising a substrate layer, the substrate layer to be included in an integrated circuit package, and a photoresist on the substrate layer, the photoresist including indium.
Example 2 includes the apparatus of example 1, wherein the photoresist includes at least one of an ethyl group, a methyl group, an isopropyl group, or a tert-butyl group.
Example 3 includes the apparatus of example 1, wherein the photoresist includes nitrogen.
Example 4 includes the apparatus of example 3, wherein the photoresist includes oxygen.
Example 5 includes the apparatus of example 1, wherein the photoresist includes an opening that exposes a portion of the substrate layer.
Example 6 includes the apparatus of example 1, wherein the photoresist is a thin film composed of clusters, ones of the clusters including more than two metal atoms that are bonded to both an oxygen atom and a ligand, the two metal atoms including the indium.
Example 7 includes the apparatus of example 6, wherein the thin film has a thickness less than or equal to approximately 10 nanometers.
Example 8 includes the apparatus of example 1, wherein the indium exists in a +1 oxidation state.
Example 9 includes an apparatus comprising a substrate layer, and a photoresist layer coated on the substrate layer, the photoresist layer including a plurality of molecular clusters, the molecular clusters including indium and oxygen.
Example 10 includes the apparatus of example 9, wherein the photoresist layer includes a thickness less than or equal to approximately 10 nanometers.
Example 11 includes the apparatus of example 9, wherein the photoresist layer includes at least one of an alkyl group or nitrogen.
Example 12 includes the apparatus of example 11, wherein the alkyl group is bound to indium, and the nitrogen is bound to indium.
Example 13 includes the apparatus of example 9, wherein the photoresist layer includes a monodentate ligand.
Example 14 includes the apparatus of example 9, wherein the photoresist layer includes at least one of a bidentate ligand or a tridentate ligand.
Example 15 includes a method comprising depositing indium-based molecular clusters on a substrate, the substrate to be included in an integrated circuit package, exposing a first portion of the indium-based molecular clusters to light using a photomask, and removing the first portion or a second portion of the indium-based molecular clusters to partially expose the substrate, the second portion not exposed to the light.
Example 16 includes the method of example 15, further including producing an indium-based precursor by causing a salt elimination reaction to occur, and causing the indium-based precursor to react with a coreactant to produce the indium-based molecular clusters.
Example 17 includes the method of example 16, wherein producing the indium-based precursor includes causing a comproportionation reaction to occur.
Example 18 includes the method of example 17, wherein the comproportionation reaction occurs after the salt elimination reaction.
Example 19 includes the method of example 15, wherein depositing the indium-based molecular clusters on the substrate includes spin coating the indium-based molecular clusters on the substrate.
Example 20 includes the method of example 15, wherein depositing the indium-based molecular clusters on the substrate includes chemical vapor depositing or atomic layer depositing the indium-based molecular clusters on the substrate.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a substrate layer, the substrate layer to be included in an integrated circuit package; and
a photoresist on the substrate layer, the photoresist including indium.

2. The apparatus of claim 1, wherein the photoresist includes at least one of an ethyl group, a methyl group, an isopropyl group, or a tert-butyl group.

3. The apparatus of claim 1 or claim 2, wherein the photoresist includes nitrogen.

4. The apparatus of claim 3, wherein the photoresist includes oxygen.

5. The apparatus of any preceding claim, wherein the photoresist includes an opening that exposes a portion of the substrate layer.

6. The apparatus of any preceding claim, wherein the photoresist is a thin film composed of clusters, ones of the clusters including more than two metal atoms that are bonded to both an oxygen atom and a ligand, the two metal atoms including the indium.

7. The apparatus of claim 6, wherein the thin film has a thickness less than or equal to approximately 10 nanometers.

8. The apparatus of any preceding claim, wherein the indium exists in a +1 oxidation state.

9. The apparatus of any preceding claim, wherein the photoresist includes at least one of an alkyl group or nitrogen.

10. The apparatus of claim 9, wherein the alkyl group is bound to indium, and the nitrogen is bound to indium.

11. The apparatus of any preceding claim, wherein the photoresist includes a monodentate ligand, a bidentate ligand, or a tridentate ligand.

12. A method comprising:
depositing indium-based molecular clusters on a substrate, the substrate to be included in an integrated circuit package;
exposing a first portion of the indium-based molecular clusters to light using a photomask; and
removing the first portion or a second portion of the indium-based molecular clusters to partially expose the substrate, the second portion not exposed to the light.

13. The method of claim 12, further including:
producing an indium-based precursor by causing a salt elimination reaction to occur; and
causing the indium-based precursor to react with a coreactant to produce the indium-based molecular clusters.

14. The method of claim 13, wherein producing the indium-based precursor includes causing a comproportionation reaction to occur after the salt elimination reaction.

15. The method of any of claims 12-14, wherein depositing the indium-based molecular clusters on the substrate includes spin coating, chemical vapor depositing, or atomic layer depositing the indium-based molecular clusters on the substrate.
